# EUROPEAN PATENT APPLICATION

(11) **EP 4 661 081 A1**
(43) Date of publication of application: **10.12.2025**
(21) Application number: 23922311.8
(22) Date of filing: 27.09.2023
(51) Int. Cl.: H01L 23/64

(54) **CAPACITOR, STORAGE ARRAY, MEMORY, AND ELECTRONIC DEVICE**

(30) Priority: 14.02.2023 CN 202310161413
(71) Applicant: Huawei Technologies Co., Ltd., Shenzhen, Guangdong 518129 (CN)
(72) Inventor: LIN, Qi, Shenzhen, Guangdong 518129 (CN); BU, Sitong, Shenzhen, Guangdong 518129 (CN); FANG, Yichen, Shenzhen, Guangdong 518129 (CN); XU, Jeffrey Junhao, Shenzhen, Guangdong 518129 (CN)
(74) Representative: Isarpatent
(86) International application number: PCT/CN2023/122329
(87) International publication number: WO 2024/169193

(57) **Abstract**

This application provides a capacitor, a memory array, a memory, and an electronic device. The capacitor includes at least two planar electrodes that are spaced apart and stacked, where each planar electrode is provided with a first via; a first dielectric layer, where the first dielectric layer is located between the two adjacent planar electrodes; a columnar electrode, where at least a part of the columnar electrode is located in the first vias of the at least two planar electrodes; a second dielectric layer, where at least a part of the second dielectric layer is located in the first vias of the at least two planar electrodes, and the second dielectric layer surrounds a side surface of the columnar electrode; and a first plate and a second plate, where the first plate is connected to at least one first planar electrode in the at least two planar electrodes, and the second plate is connected to at least one second planar electrode in the at least two planar electrodes; or the first plate is connected to at least one first columnar electrode, and the second plate is connected to at least one second columnar electrode. Capacitance density of the capacitor can be improved according to this application.

## Description

This application claims priority to Chinese Patent Application No. 202310161413.7, filed with the China National Intellectual Property Administration on February 14, 2023 and entitled "CAPACITOR, MEMORY ARRAY, MEMORY, AND ELECTRONIC DEVICE", which is incorporated herein by reference in its entirety.

### TECHNICAL FIELD

This application relates to the field of information storage technologies, and in particular, to a capacitor, a memory array, a memory, and an electronic device.

### BACKGROUND

Currently, most electronic devices are equipped with memories. The memory may be configured to perform a write operation and/or a read operation, to store information and/or read information. To filter out power supply noise in the memory, a capacitor may usually be disposed in the memory, and the capacitor is disposed on a substrate of the memory.

In a related technology, the capacitor includes a first interdigitated electrode and a second interdigitated electrode, and the first electrode and the second electrode are disposed at a same layer. Consequently, utilization of the memory in a thickness direction is low, and capacitance density of the capacitor is low.

### SUMMARY

To resolve the foregoing technical problems, this application provides a capacitor, a memory array, a memory, and an electronic device, to improve capacitance density of the capacitor.

This application provides a capacitor, including at least two planar electrodes, a first dielectric layer, a columnar electrode, a second dielectric layer, a first plate, and a second plate. The at least two planar electrodes are spaced apart and stacked, and each planar electrode is provided with a first via. The planar electrode located at a bottom has a first surface facing another planar electrode, and the first vias of the planar electrodes have projection on the first surface that completely overlaps, or partially overlaps, or does not overlap. The first dielectric layer is located between the two adjacent planar electrodes. The second dielectric layer surrounds a side surface of the columnar electrode, at least a part of the columnar electrode is located in the first via of the at least two planar electrodes, and at least a part of the second dielectric layer is also located in the first via of the at least two planar electrodes.

For a connection relationship between the first plate, the second plate, the planar electrode, and the columnar electrode, in a possible implementation, and the first plate and the second plate are connected to the at least two planar electrodes respectively, that is, the first plate is connected to at least one first planar electrode in the at least two planar electrodes, and the second plate is connected to at least one second planar electrode in the at least two planar electrodes. In another possible implementation, there are at least two columnar electrodes, the first plate and the second plate are connected to the at least two columnar electrodes respectively, that is, the first plate is connected to at least one first columnar electrode, and the second plate is connected to at least one second columnar electrode.

In this application, at least the part of the columnar electrode and at least the part of the second dielectric layer are located in the first vias of the planar electrodes, and the second dielectric layer surrounds the side surface of the columnar electrode, that is, the second dielectric layer is located between the planar electrode and the columnar electrode. Therefore, for one of the planar electrodes, the planar electrode, the second dielectric layer located in the first via of the planar electrode, and the columnar electrode located in the first via of the planar electrode may form one capacitor unit. In this application, it is equivalent to connecting capacitor units corresponding to all planar electrodes in parallel. Therefore, a capacitance value of the capacitor in this application is high. In other words, when a same area is occupied on a second surface of a substrate of a memory, a larger capacitance value can be obtained in this application, so that higher capacitance density can be obtained. In addition, in this application, three-dimensional space can be further fully used, and a large quantity of planar electrodes and a large quantity of first dielectric layers can be disposed, to obtain higher capacitance density. It may be understood that the capacitance density of the capacitor is a ratio of a capacitance value of the capacitor to an area occupied by the capacitor on a surface of the memory.

In some possible implementations, the first dielectric layer is provided with a second via, projection of the first via on the planar electrode overlaps projection of the second via on the planar electrode, a part of the columnar electrode is further located in the second via, and a part of the second dielectric layer is further located in the second via. In this way, the columnar electrode and the second dielectric layer penetrate a plurality of planar electrodes and the first dielectric layer located between every two adjacent planar electrodes, that is, the columnar electrode and the second dielectric layer penetrate an entire height of the capacitor. Therefore, a distribution area of electric field lines generated between the columnar electrode and the planar electrode is larger, and the capacitance density of the capacitor can be further improved.

To simplify a manufacturing process, projection of the first via and the second via on any planar electrode coincides. In this way, the columnar electrode extends in a stacking direction of the at least two planar electrodes, that is, the extension direction of the columnar electrode is perpendicular to a plate surface of the planar electrode, and the extension direction of the columnar electrode is the same as a thickness direction of the capacitor. Therefore, the second dielectric layer and the columnar electrode may be manufactured in a same process.

In a possible implementation, each planar electrode is provided with at least two first vias, the capacitor includes at least two columnar electrodes and at least two second dielectric layers, the at least two columnar electrodes are respectively located in the at least two first vias of each planar electrode, and the at least two second dielectric layers are respectively located in the at least two first vias of each planar electrode. In this way, each via of the planar electrode, and the columnar electrode and the second dielectric layer that are located in the vias may form one capacitor unit. Therefore, a plurality of capacitor units may be formed between each planar electrode, the columnar electrode, and the second dielectric layer, and the plurality of capacitor units are all connected in parallel, to further improve the capacitance value and the capacitance density.

When there are at least two columnar electrodes, the first plate is connected to a part of the columnar electrodes, and the second plate is connected to the other part of the columnar electrodes. In other words, the first plate is disposed on the part of the columnar electrodes, and the second plate is disposed on the other part of the columnar electrodes. One planar electrode, two columnar electrodes, and second dielectric layers located between the planar electrode and the columnar electrodes may form two capacitor units. For ease of description, the two columnar electrodes are referred to as a first columnar electrode and a second columnar electrode. The first plate is disposed on the first columnar electrode, and the second plate is disposed on the second columnar electrode. In this case, the planar electrode, the first columnar electrode, and the second dielectric layer located between the planar electrode and the first columnar electrode may form a first capacitor unit, the planar electrode, the second columnar electrode, and the second dielectric layer located between the planar electrode and the second columnar electrode may form a second capacitor unit, and the first capacitor unit and the second capacitor unit are connected in series. In addition, first capacitor units formed by a same planar electrode and different first columnar electrodes are all connected in parallel, and second capacitor units formed by a same planar electrode and different second columnar electrodes are all connected in parallel, to form a combined capacitor between each planar electrode and the columnar electrodes. Combined capacitors corresponding to different planar electrodes are all connected in parallel. When the first capacitor units are connected in parallel and the second capacitor units are connected in parallel, the capacitance value of the capacitor can be improved, to further improve the capacitance density of the capacitor. When the first capacitor unit and the second capacitor unit are connected in series, a voltage withstand capability of the capacitor can be improved. In addition, when the first capacitor unit is faulty, the second capacitor unit connected in series to the first capacitor unit can still be used. This can improve reliability of the capacitor, and reduce a risk of a fault.

In some possible implementations, the capacitor further includes at least two electrode extension portions disposed on the at least two columnar electrodes respectively, the first plate is in contact with a part of the electrode extension portions, and the second plate is in contact with the other part of the electrode extension portions. Because the electrode extension portion is disposed on the columnar electrode, when the first plate is in contact with the part of the electrode extension portions, the first plate can be electrically connected to the part of the electrodes; and when the second plate is in contact with the other part of the electrode extension portions, the second plate may be electrically connected to the other part of the electrodes. In a procedure of manufacturing the capacitor in this application, after the second dielectric layer and the columnar electrode are separately manufactured, the second dielectric layer and the columnar electrode are polished, so that the columnar electrode is flush with the second dielectric layer. The electrode extension portion may be manufactured on each columnar electrode, and the first plate and the second plate may be separately manufactured on the electrode extension portions, to simplify a manufacturing process.

In addition, the electrode extension portion in contact with the first plate and the electrode extension portion in contact with the second plate are located at a same end of the columnar electrodes, and the first plate and the second plate are at a same layer and are of a same material. In this way, the electrode extension portions may be manufactured in a same process, and the first plate and the second plate may be manufactured in a same process. This can further simplify a manufacturing process.

In addition, to enable the planar electrodes to be equipotentially bonded, the capacitor further includes a first conductive connection portion, and each planar electrode is in contact with the first conductive connection portion.

When the first plate and the second plate are connected to the at least two planar electrodes respectively, the first plate is connected to a part of the planar electrodes, and the second plate is connected to the other part of the planar electrodes. For ease of description, the at least two planar electrodes may include the first planar electrode and the second planar electrode, there may be one first planar electrode or at least two first planar electrodes, and there may also be one second planar electrode or at least two second planar electrodes. Herein, an example in which there are at least two first planar electrodes and at least two second planar electrodes is used for description. The first planar electrode, each columnar electrode, and the second dielectric layer located between the first planar electrode and the columnar electrode may form one first capacitor unit, and a combined capacitor formed by the first planar electrode and a plurality of columnar electrodes is obtained by connecting a plurality of first capacitor units in parallel. The second planar electrode, each columnar electrode, and the second dielectric layer located between the second planar electrode and the columnar electrode may form one second capacitor unit, and a combined capacitor formed by the second planar electrode and a plurality of columnar electrodes is obtained by connecting a plurality of second capacitor units in parallel. A first capacitor unit and a second capacitor unit that are formed based on a same columnar electrode are connected in series. When the plurality of first capacitor units are connected in parallel and the plurality of second capacitor units are connected in parallel, the capacitance value of the capacitor can be improved, to further improve the capacitance density of the capacitor. In addition, when the first capacitor unit and the second capacitor unit are connected in series, the voltage withstand capability of the capacitor can be improved. In addition, when the first capacitor unit is faulty, the second capacitor unit connected in series to the first capacitor unit can still be used. This can improve reliability of the capacitor, and reduce a risk of a fault.

In addition, the capacitor further includes a second conductive connection portion and a third conductive connection portion, the second conductive connection portion is located between the first planar electrode and the first plate, and the third conductive connection portion is located between the second planar electrode and the second plate. Because the planar electrodes are stacked and spaced apart, the first planar electrode and the second planar electrode are also stacked and spaced apart. In this case, the first planar electrode and the second planar electrode have different heights in the stacking direction. When the second conductive connection portion is located between the first planar electrode and the first plate, and the third conductive connection portion is located between the second planar electrode and the second plate, heights of the second conductive connection portion and the third conductive connection portion may be set, so that the first plate and the second plate are disposed at a same layer. In addition, when the first plate and the second plate are further manufactured by using a same material, the first plate and the second plate may be manufactured in a same process, to simplify a manufacturing process.

In addition, a height from each first planar electrode to a bottom of the capacitor is higher than a height from each second planar electrode to the bottom. If the capacitor is divided into a high region and a low region in the thickness direction, a height between the high region and the second surface of the substrate is greater than a height between the low region and the second surface of the substrate. In this case, each first planar electrode is located in the high region, and each second planar electrode is located in the low region. This can reduce cases in which a short circuit occurs between a plurality of second conductive connection portions because some first planar electrodes are located in the high region and some first planar electrodes are located in the low region.

In a possible implementation, in every two first planar electrodes, the first planar electrode close to the bottom has a first connection region, projection that is of the first planar electrode away from the bottom and that is on the first planar electrode close to the bottom does not overlap the first connection region, and the second conductive connection portion is disposed in the first connection region. Projection that is of the second conductive connection portion and that is on the first planar electrode close to the bottom falls within a range of the first connection region. Because the projection that is of the first planar electrode away from the bottom and that is on the first planar electrode close to the bottom does not overlap the first connection region, there is no overlap between projection that is on any first planar electrode and that is of a second conductive connection portion disposed on the first planar electrode away from the bottom and projection that is on the first planar electrode and that is of a second conductive connection portion disposed on the first planar electrode close to the bottom. Therefore, a short circuit does not occur between the two second conductive connection portions.

Similarly, in every two second planar electrodes, the second planar electrode close to the bottom has a second connection region, projection that is of the second planar electrode away from the bottom and that is on the second planar electrode close to the bottom does not overlap the second connection region, and the third conductive connection portion is disposed in the second connection region. Projection that is of the third conductive connection portion and that is on the first planar electrode close to the bottom falls within the range of the first connection region. Because the projection that is of the second planar electrode away from the bottom and that is on the first planar electrode close to the bottom does not overlap the first connection region, there is no overlap between projection that is on any second planar electrode and that is of a third conductive connection portion disposed on the second planar electrode away from the bottom and projection that is on the second planar electrode and that is of a third conductive connection portion disposed on the second planar electrode close to the bottom. Therefore, a short circuit does not occur between the two third conductive connection portions.

In some possible implementations, the first plate and the second plate are respectively located at two sides of the columnar electrode. For ease of description, the two sides are a first side and a second side. In this way, each second conductive connection portion may be located at the first side of the columnar electrode, and each third conductive connection portion may be located at the second side of the columnar electrode, to increase a distance between any second conductive connection portion and any third conductive connection portion, and reduce cases in which a short circuit occurs between second conductive connection portions and third conductive connection portions.

In addition, to enable the planar electrodes to be equipotentially bonded, the capacitor further includes a fourth conductive connection portion, and each columnar electrode is in contact with the fourth conductive connection portion.

In some possible implementations, a surface that is of the second dielectric layer and that faces the columnar electrode is a wavy surface. This can increase a surface area of the second dielectric layer, to further improve the capacitance density of the capacitor.

In addition, a material of the second dielectric layer includes at least one of ZrOₓ, HfOₓ, SiOₓ, AlOₓ, TiOₓ, LaOₓ, TaOₓ, and SiNₓ, and x is greater than 0 and less than or equal to 10. All the foregoing materials are materials with high dielectric constants, and a dielectric constant of the materials is greater than or equal to 20 and less than or equal to 40. Because the capacitance value of the capacitor is positively correlated with a dielectric constant of the second dielectric layer, a higher dielectric constant of the second dielectric layer indicates a higher capacitance value of the capacitor, and higher capacitance density of the capacitor.

This application further provides a memory array, including a switching transistor and the capacitor in any one of the foregoing implementations. The switching transistor is electrically connected to the capacitor. The memory array can implement all effect of the capacitor.

This application further provides a memory, including a controller and the foregoing memory array. The controller is electrically connected to the memory array. The memory can implement all effect of the memory array.

This application further provides an electronic device, including a circuit board and the foregoing memory. The circuit board is electrically connected to the memory. The electronic device can implement all effect of the memory.

### BRIEF DESCRIPTION OF DRAWINGS

To describe technical solutions in embodiments of this application more clearly, the following briefly introduces accompanying drawings required for describing embodiments of this application. It is clear that the accompanying drawings in the following description show merely some embodiments of this application, and a person of ordinary skill in the art may still derive other drawings from these accompanying drawings without creative efforts.
FIG. 1 is a diagram of a structure of an electronic device;
FIG. 2a is a diagram of a structure of a memory in FIG. 1;
FIG. 2b is a top view of a substrate in FIG. 2a;
FIG. 3 is a diagram of a structure of a capacitor in a related technology;
FIG. 4a is a diagram of a structure of a capacitor according to a first embodiment of this application;
FIG. 4b is a diagram of a structure of a capacitor according to a second embodiment of this application;
FIG. 4c is a diagram of a structure of a capacitor according to a third embodiment of this application;
FIG. 4d is a diagram of a structure of a capacitor according to a fourth embodiment of this application;
FIG. 4e is a diagram of a structure of a capacitor according to a fifth embodiment of this application;
FIG. 5 is a diagram of a three-dimensional structure of the capacitor in FIG. 4a;
FIG. 6 is a circuit diagram of the capacitor in FIG. 4a;
FIG. 7a is a diagram of a structure of a capacitor according to a sixth embodiment of this application;
FIG. 7b is a diagram of a structure of a capacitor according to a seventh embodiment of this application;
FIG. 7c is a diagram of a structure of a capacitor according to an eighth embodiment of this application;
FIG. 8 is a diagram of a three-dimensional structure of the capacitor in FIG. 7a; and
FIG. 9 is a circuit diagram of the capacitor in FIG. 7a.

Reference numerals: 11: controller; 12: memory; 121: switching transistor; 122: peripheral circuit; 123: substrate; 1231: second surface; 1232: step region; 1233: step structure; 13: memory array; 20: capacitor; 21: first electrode; 211: first connection portion; 212: first interdigital; 22: second electrode; 221: second connection portion; 222: second interdigital; 23: dielectric layer; 24: planar electrode; 241: first planar electrode; 242: second planar electrode; 243: first connection region; 244: second connection region; 245: first via; 246: first surface; 25: first dielectric layer; 251: second via; 26: columnar electrode; 261: first columnar electrode; 262: second columnar electrode; 27: second dielectric layer; 28: first plate; 29: second plate; 31: electrode extension portion; 311: first electrode extension portion; 312: second electrode extension portion; 32: conductive component; 33: first conductive connection portion; 34: second conductive connection portion; 35: third conductive connection portion; and 36: fourth conductive connection portion.

### DESCRIPTION OF EMBODIMENTS

The following clearly and completely describes technical solutions in embodiments of this application with reference to accompanying drawings in embodiments of this application. It is clear that the described embodiments are some but not all of embodiments of this application. All other embodiments obtained by a person of ordinary skill in the art according to embodiments of this application without creative efforts shall fall within the protection scope of this application.

The term "and/or" in this specification describes only an association relationship for describing associated objects and represents that three relationships may exist. For example, A and/or B may represent the following three cases: Only A exists, both A and B exist, and only B exists.

In the specification and claims in embodiments of this application, the terms "first", "second", and so on are intended to distinguish between different objects but do not indicate a particular order of the objects. For example, a first target object and a second target object are used to distinguish between different target objects, but are not used to describe a particular order of the target objects.

In embodiments of this application, a word such as "example" or "for example" is used to give an example, an illustration, or a description. Any embodiment or design scheme described as "example" or "for example" in embodiments of this application should not be explained as being more preferred or having more advantages than another embodiment or design scheme. Exactly, use of the word "example", "for example", or the like is intended to present a related concept in a specific manner.

In descriptions of embodiments of this application, "a plurality of" means two or more, unless otherwise specified. For example, a plurality of processing units are two or more processing units, and a plurality of systems are two or more systems.

For ease of description, three directions may be defined: a first direction (an X direction) that indicates a length direction of a memory, a second direction (a Y direction) that indicates a width direction of the memory, and a third direction (a Z direction) that indicates a height direction of the memory. Every two of the X direction, the Y direction, and the Z direction are pairwise perpendicular.

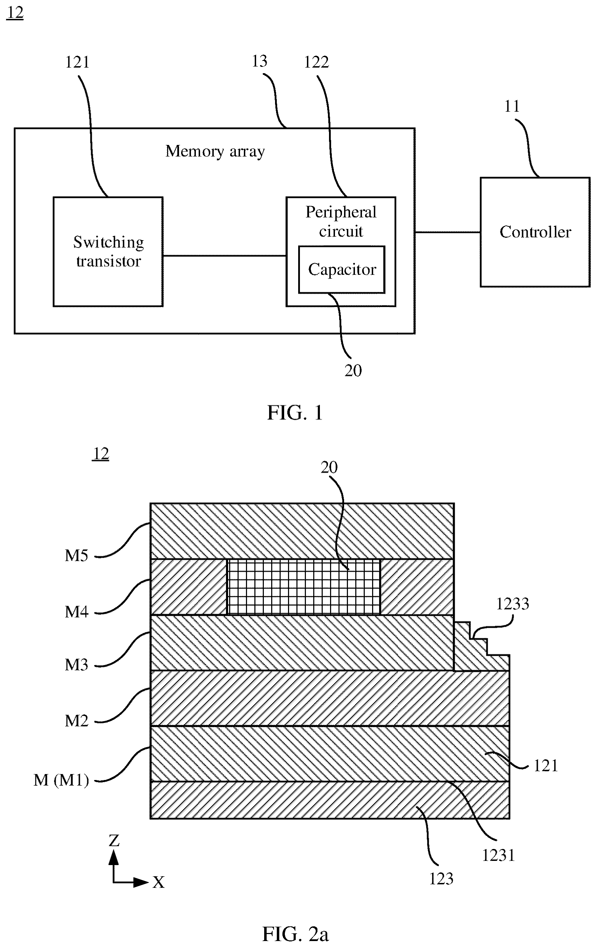

Currently, most electronic devices are equipped with a circuit board and a memory 12 shown in FIG. 1, and the circuit board is electrically connected to the memory 12. The memory 12 may be configured to perform a write or read operation. When performing the write operation, the memory 12 may store information. When performing the read operation, the memory 12 may read information stored in the memory 12. The controller 11 may be configured to send an instruction to the memory 12, so that the memory 12 performs the write or read operation according to the instruction. The electronic device herein may be a mobile phone, a tablet computer, a wearable device, an augmented reality (augmented reality, AR) device, a notebook computer, an ultra-mobile personal computer (personal digital assistant, PDA), or the like. The memory 12 may be a ferroelectric random access memory (ferroelectric random access memory, FeRAM) or a dynamic random access memory (dynamic random access memory, DRAM).

As shown in FIG. 1, the memory 12 may include a controller 11 and a memory array 13, and the controller 11 is electrically connected to the memory array 13. The memory array 13 may include a switching transistor 121 and a peripheral circuit 122. The switching transistor 121 is electrically connected to the peripheral circuit 122. The peripheral circuit 122 may include a capacitor 20. The capacitor 20 may be a decoupling capacitor (decoupling capacitor), and the decoupling capacitor may filter out power supply noise in the memory 12. In addition, a higher capacitance value of the decoupling capacitor indicates better filtering effect. To achieve good filtering effect, an area occupied by the decoupling capacitor on a substrate may usually reach more than 10%. Certainly, the capacitor 20 may alternatively be a capacitor 20 without a decoupling function.

As shown in FIG. 2a, the memory 12 further includes a substrate 123, and both the switching transistor 121 and the capacitor 20 are disposed on a second surface 1231 of the substrate 123.

In a related technology, as shown in FIG. 2a, the capacitor 20 includes a first interdigitated electrode 21 and a second interdigitated electrode 22. The first electrode 21 includes a first connection portion 211 and a plurality of first interdigitals 212 disposed on the first connection portion 211. The second electrode 22 includes a second connection portion 221 and a plurality of second interdigitals 222 disposed on the second connection portion 221. The first interdigital 212 and the second interdigital 222 are disposed in a staggered manner, a dielectric layer 23 is disposed between a first interdigital 212 and a second interdigital 222 that are adjacent, the first interdigital 212 and the second interdigital 222 that are adjacent and the dielectric layer 23 located between the first interdigital 212 and the second interdigital 222 may form one capacitor unit, the capacitor 20 is formed by connecting a plurality of capacitor units in parallel.

In the related technology, because the first electrode 21 and the second electrode 22 are disposed at a same layer, space utilization in the Z direction is not high. Consequently, when a same area is occupied on the second surface 1231 of the substrate 123 shown in FIG. 2a, a capacitance value of the capacitor 20 is low. Alternatively, to obtain a high capacitance value, a quantity of first electrodes 21 and a quantity of second electrodes 22 need to be increased, or sizes of the first electrode 21 in the X direction and the Y direction and sizes of the second electrode 22 in the X direction and the Y direction need to be increased. In this way, the area occupied by the capacitor 20 on the second surface 1231 is increased. The capacitance density of the capacitor 20 is a ratio of the capacitance value of the capacitor 20 to the area occupied by the capacitor 20 on the second surface 1231 of the substrate 123. In this case, the capacitance density of the capacitor 20 in the related technology is low.

In view of this, an embodiment of this application provides a capacitor. The capacitor may be a decoupling capacitor, or may be another capacitor that does not have a decoupling function, to improve capacitance density of the capacitor.

As shown in FIG. 2a, the memory 12 may further include a plurality of metal layers M disposed on the substrate 123. For example, as shown in FIG. 1, the memory 12 includes five metal layers M: a first metal layer M1, a second metal layer M2, a third metal layer M3, a fourth metal layer M4, and a fifth metal layer M5.

The capacitor 20 may be disposed in one of the metal layers M or two of the metal layers M. For example, as shown in FIG. 2a, the capacitor 20 may be disposed in the fourth metal layer M4. For another example, the capacitor 20 may be disposed in the fifth metal layer M5. For another example, a part of the capacitor 20 is disposed in the fourth metal layer M4, and the other part is disposed in the fifth metal layer M5.

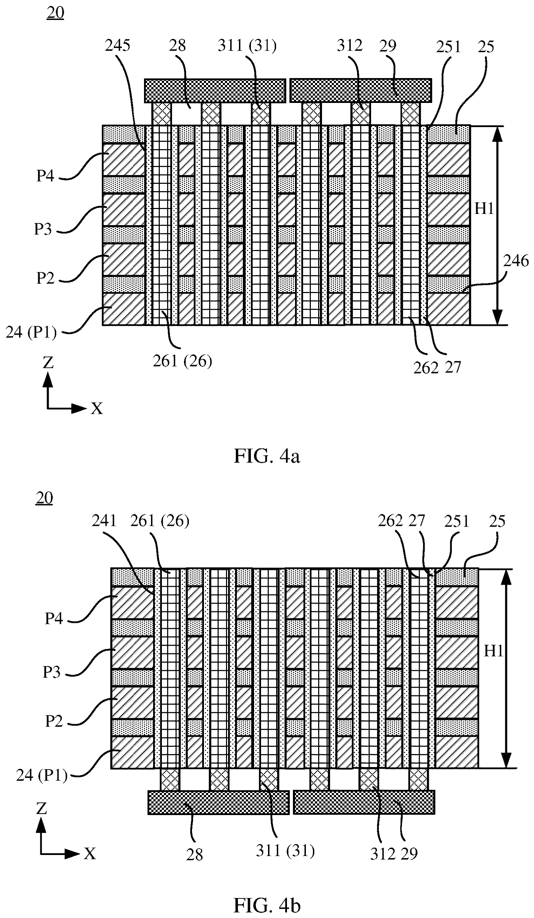

As shown in FIG. 4a, the capacitor 20 includes planar electrodes 24, a first dielectric layer 25, a columnar electrode 26, a second dielectric layer 27, a first plate 28, and a second plate 29.

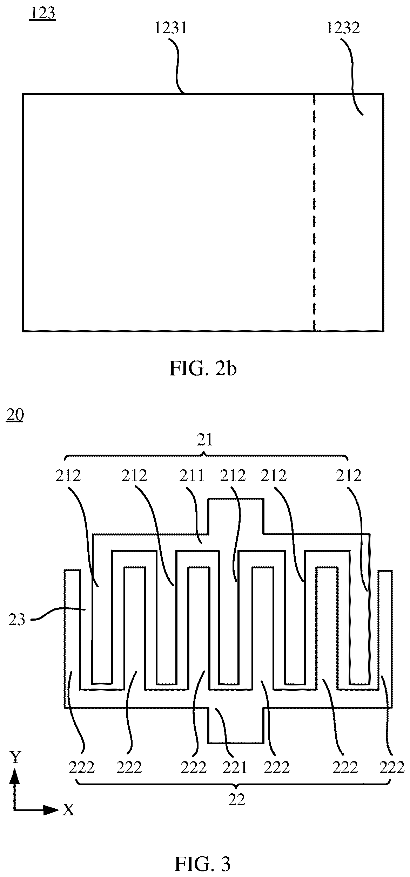

There are at least two planar electrodes 24, and the at least two planar electrodes 24 are spaced apart and stacked. The at least two planar electrodes 24 being stacked and spaced apart may mean that the at least two planar electrodes 24 are sequentially stacked, and there is a spacing between every two planar electrodes 24. For example, as shown in FIG. 3, there are four planar electrodes 24. For ease of description, the four planar electrodes 24 are P1, P2, P3, and P4. The 1^{st} planar electrode P1 is located at a bottom layer of the four planar electrodes 24, and the 4^{th} planar electrode P4 is located at a top layer of the four planar electrodes 24. It may be understood that the bottom layer is closer to the substrate 123 shown in FIG. 2a, and the top layer is farther away from the substrate 123 shown in FIG. 2a. The planar electrode P4 located at the bottom layer has a first surface 246 facing the other planar electrodes 24.

A material of the planar electrode 24 may be a conductive material, for example, may be polycrystalline silicon, W, TiN, Ti, Co, Ni, or Ru. In addition, materials of the planar electrodes 24 may be the same or may be different.

Each planar electrode 24 is provided with a first via 245. Each planar electrode 24 has one first via 245 or at least two first vias 245. The following mainly uses an example in which each planar electrode 24 is provided with the at least two first vias 245 for description. For an arrangement manner of the first vias 245 on each planar electrode 24, in an example, the at least two first vias 245 may be arranged in a straight line. For example, the at least two first vias 245 are arranged in the X direction, or the at least two first vias 245 are arranged in the Y direction. In another example, the at least two first vias 245 may alternatively be arranged in an array. For example, the at least two first vias 245 are arranged in a rectangular array. In another example, the at least two first vias 245 may alternatively be arranged in a triangular array or a circular array. However, it may be understood that, because projection of the capacitor 20 on a plane determined based on the X direction and the Y direction is usually rectangular, when the at least two first vias 245 are arranged in a rectangular array, utilization of the area of the second surface of the substrate of the memory can be maximized.

As shown in FIG. 4a, in this embodiment, projection that is of the first vias 245 of the planar electrodes 24 and that is on the first surface 246 completely coincides. In another embodiment, projection that is of the first vias 245 of the planar electrodes 24 and that is on the first surface 246 partially overlaps, or does not overlap.

As shown in FIG. 4a, there may be at least two first dielectric layers 25, and a quantity of first dielectric layers 25 may be the same as a quantity of planar electrodes 24. In the at least two first dielectric layers 25, one first dielectric layer 25 is disposed on a side that is of the planar electrode 24 at the top layer and that is away from the other planar electrodes 24, and the other first dielectric layer 25 is located between two adjacent planar electrodes 24. For example, as shown in FIG. 4a, when there are four planar electrodes 24, there are also four first dielectric layers 25. Three first dielectric layers 25 are separately located between two adjacent planar electrodes 24, and one first dielectric layer 25 is located at the side that is of the planar electrode 24 at the top layer and that is away from the other planar electrodes 24.

As shown in FIG. 4a, each first dielectric layer 25 is provided with a second via 251, and projection of the first via 245 on the first surface 246 overlaps projection of the second via 251 on the first surface 246. For example, projection of the first via 245 on the first surface 246 coincides with projection of the second via 251 on the first surface 246. In this way, projection that is of the first via 245 of each planar electrode 24 and that is on the first surface 246 coincides with projection that is of the second via 251 on each first dielectric layer 25 and that is on the first surface 246. Therefore, after the planar electrodes 24 and the first dielectric layers 25 are manufactured, the first vias 245 and the second vias 251 can be processed in a same process.

A material of the first dielectric layer 25 may include at least one of SiOₓ and SiNₓ, or a material of the first dielectric layer 25 may include at least one of SiOₓ and SiNₓ and a dopant thereof, where x is greater than 0 and less than or equal to 10. SiOₓ and SiNₓ have features such as low costs and good insulation effect, to reduce manufacturing costs of the capacitor 20.

As shown in FIG. 4a, a quantity of columnar electrodes 26 is the same as a quantity of first vias 245 of each planar electrode 24, and may be one or at least two. Similarly, the following uses an example in which there are at least two columnar electrodes 26 for description.

As shown in FIG. 4a, in a possible implementation, the columnar electrode 26 is located in the first via 245 of each planar electrode 24 and the second via 251 of the first dielectric layer 25. In other words, a part of the columnar electrode 26 is located in the first via 245, and the other part of the columnar electrode 26 is located in the second via 251. A height of the columnar electrode 26 in the Z direction is the same as a height H1 from a surface that is of a first dielectric layer 25 at a top layer and that is away from the other first dielectric layers 25 to a surface that is of the planar electrode 24 at the bottom layer and that is away from the other planar electrodes 24. In other words, the columnar electrode 26 penetrates from the first via 245 of the planar electrode 24 at the bottom layer to the second via 251 of the first dielectric layer 25 at the top layer. When projection that is of the first vias 245 of the planar electrodes 24 and that is on the first surface 246 completely coincides, and projection of the first vias 245 on the first surface 246 completely coincides with projection of the second vias 251 on the first surface 246, projection of the columnar electrodes 26 on the first surface 246 also coincides. Therefore, the columnar electrodes 26 may be manufactured in a same process.

In addition, a material of each columnar electrode 26 may be a conductive material, for example, may be polycrystalline silicon, W, TiN, Ti, Co, Ni, or Ru. In addition, for materials for forming the columnar electrodes 26, the materials of the columnar electrodes 26 may be different. Alternatively, the materials of the columnar electrodes 26 may be the same. In this way, the columnar electrodes 26 may be manufactured in a same process, to simplify a manufacturing process.

In another possible implementation, the columnar electrode 26 includes at least two sub-electrodes that extend in the Z direction and are arranged in the Z direction, the at least two sub-electrodes are electrically connected in sequence, and the at least two sub-electrodes are respectively located in the first vias 245 of the at least two planar electrodes 24.

As shown in FIG. 4a, a quantity of second dielectric layers 27 is the same as a quantity of columnar electrodes 26. For example, when there is one columnar electrode 26, there is also one second dielectric layer 27. When there are at least two columnar electrodes 26, there are also at least two second dielectric layers 27.

As shown in FIG. 4a, each second dielectric layer 27 surrounds a side surface of each columnar electrode 26. The second dielectric layer 27 is located in the first via 245 of each planar electrode 24 and the second via 251 of the first dielectric layer 25. In other words, a part of the second dielectric layer 27 is located in the first via 245, and the other part of the second dielectric layer 27 is located in the second via 251. In other words, the second dielectric layer 27 is located between the planar electrode 24 and the columnar electrode 26.

In addition, as shown in FIG. 4a, a height of the second dielectric layer 27 in the Z direction is the same as the height H1 from the surface that is of the first dielectric layer 25 at the top layer and that is away from the other first dielectric layers 25 to the surface that is of the planar electrode 24 at the bottom layer and that is away from the other planar electrodes 24. In other words, the second dielectric layer 27 penetrates from the first via 245 of the planar electrode 24 at the bottom layer to the second via 251 of the first dielectric layer 25 at the top layer. When the projection that is of the first vias 245 of the planar electrodes 24 and that is on the first surface 246 completely coincides, and the projection of the first vias 245 on the first surface 246 completely coincides with the projection of the second vias 251 on the first surface 246, projection of the second dielectric layers 27 on the first surface 246 also coincides. Therefore, the second dielectric layers 27 may be manufactured in a same process.

For a manner in which the first plate 28 and the second plate 29 are connected to the planar electrode 24 or the columnar electrode 26, in a possible implementation, the first plate 28 and the second plate 29 are connected to the at least two columnar electrodes 26 respectively. For example, as shown in FIG. 4a, the first plate 28 is connected to a part of the columnar electrodes 26, and the second plate 29 is connected to the other part of the columnar electrodes 26. It may be understood that the connection herein may be electrical connection. In other words, the first plate 28 is disposed on the part of the columnar electrodes 26, and the second plate 29 is disposed on the other part of the columnar electrodes 26.

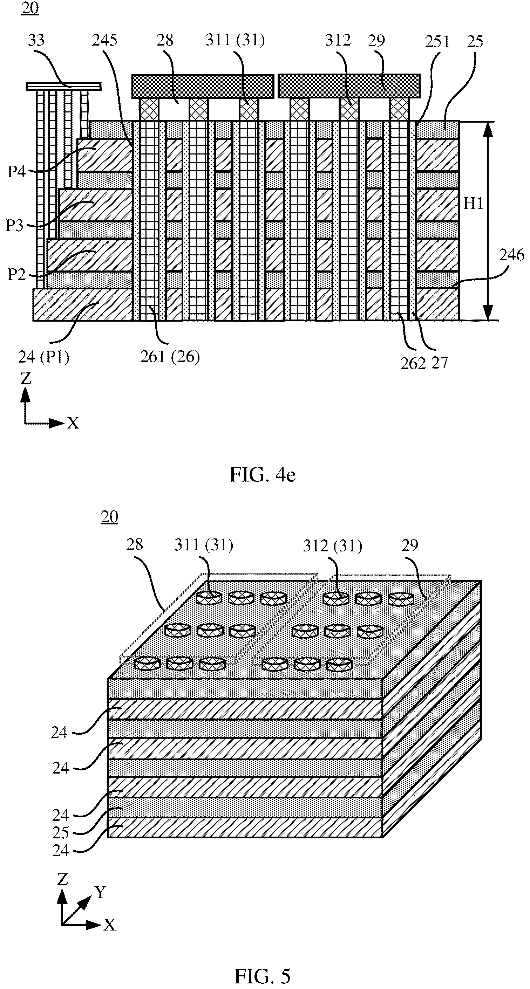

In this embodiment, as shown in FIG. 4a and FIG. 5, the quantity of the columnar electrodes 26 may be an even number, and when the at least two columnar electrodes 26 are arranged in a rectangular array, the at least two columnar electrodes 26 may be evenly divided into two parts from the middle of the rectangular array. For ease of description, a part of the columnar electrodes 26 may be referred to as a first columnar electrode 261, and the other part of the columnar electrodes 26 may be a second columnar electrode 262. In this case, a quantity of first columnar electrodes 261 is the same as a quantity of second columnar electrodes 262. In another embodiment, the quantity of columnar electrodes 26 may alternatively be an odd number.

During implementation, as shown in FIG. 4a, the capacitor 20 further includes at least two electrode extension portions 31 disposed on the at least two columnar electrodes 26 respectively, the first plate 28 is in contact with a part of the electrode extension portions 31, and the second plate 29 is in contact with the other part of the electrode extension portions 31. For ease of description, the electrode extension portion 31 disposed on the first columnar electrode 261 may be referred to as a first electrode extension portion 311, and the electrode extension portion 31 disposed on the second columnar electrode 262 may be referred to as a second electrode extension portion 312. In this case, the first plate 28 is in contact with the first electrode extension portion 311, and the second plate 29 is in contact with the second electrode extension portion 312. Because the electrode extension portion 31 is disposed on the columnar electrode 26, when the first plate 28 is in contact with the first electrode extension portion 311, the first plate 28 can be electrically connected to the first columnar electrode 261; and when the second plate 29 is in contact with the second electrode extension portion 312, the second plate 29 may be electrically connected to the second columnar electrode 262. In a procedure of manufacturing the capacitor 20 in embodiments of this application, after the second dielectric layer 27, the first columnar electrode 261, and the second columnar electrode 262 are separately manufactured, the second dielectric layer 27, the first columnar electrode 261, and the second columnar electrode 262 are polished, so that the first columnar electrode 261 and the second columnar electrode 262 are flush with the second dielectric layer 27. The first electrode extension portion 311 may be manufactured on each first columnar electrode 261, the second electrode extension portion 312 may be manufactured on each second columnar electrode 262, the first plate 28 may be manufactured on the first electrode extension portion 311, and the second plate 29 is manufactured on the second electrode extension portion 312, to simplify a manufacturing process.

For disposing positions of the first electrode extension portion 311, the second electrode extension portion 312, the first plate 28, and the second plate 29, in a possible implementation, the first electrode extension portion 311, the second electrode extension portion 312, the first plate 28, and the second plate 29 are all located at a same end of the columnar electrodes 26. For example, as shown in FIG. 4a, both the first electrode extension portion 311 and the second electrode extension portion 312 are located at an end that is of the columnar electrode 26 and that is away from the substrate 123 shown in FIG. 2a, that is, both the first electrode extension portion 311 and the second electrode extension portion 312 are located at the top of the columnar electrode 26. Correspondingly, both the first plate 28 and the second plate 29 are located at the top of the columnar electrode 26, and the first plate 28 and the second plate 29 are at a same layer and of a same material. In this way, the electrode extension portions 31 may be manufactured in a same process, and the first plate 28 and the second plate 29 may be manufactured in a same process. This can further simplify a manufacturing process. For another example, as shown in FIG. 4b, both the first electrode extension portion 311 and the second electrode extension portion 312 are located at one end that is of the columnar electrode 26 and that faces the substrate 123 shown in FIG. 2a. Correspondingly, both the first plate 28 and the second plate 29 are located at the end that is of the columnar electrode 26 and that faces the substrate 123 shown in FIG. 2a.

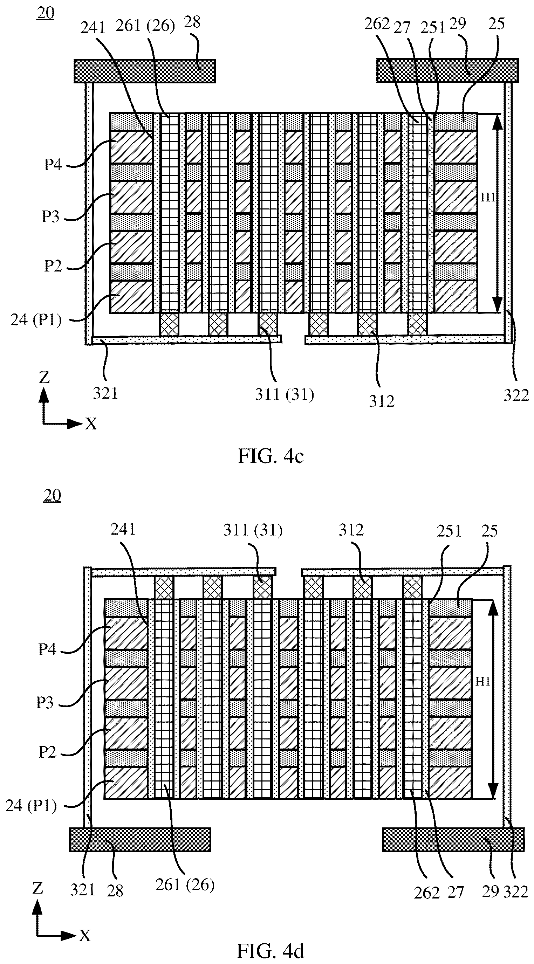

In another possible implementation, the first electrode extension portion 311 and the second electrode extension portion 312 are located at a same end of the columnar electrodes 26, the first plate 28 and the second plate 29 are located at a same end of the columnar electrodes 26, and the first electrode extension portion 311 and the first plate 28 are located at two opposite ends of the columnar electrode 26. For example, as shown in FIG. 4c, both the first electrode extension portion 311 and the second electrode extension portion 312 are located at the bottom of the columnar electrode 26, the first electrode extension portions 311 are connected in parallel at the bottom of the columnar electrode 26, and the second electrode extension portions 312 are connected in parallel at the bottom of the columnar electrode 26. The first electrode extension portions 311 may be connected in parallel by using a conductor wire, or may be connected in parallel by using a plate-shaped conductive structure, or may be connected in parallel by using an interdigital conductive structure. Similarly, the second electrode extension portions 311 are connected in parallel by using a conductor wire, or are connected in parallel by using a plate-shaped conductive structure, or are connected in parallel by using an interdigital conductive structure. After being connected in parallel, the first electrode extension portions 311 may be connected to the first plate 28 by using a first conductive device 321. After being connected in parallel, the second electrode extension portions 312 may be connected to the second plate 29 by using a second conductive device 322. For another example, as shown in FIG. 4d, both the first electrode extension portion 311 and the second electrode extension portion 312 are located at the top of the columnar electrode 26, and both the first plate 28 and the second plate 29 are located at the bottom of the columnar electrode 26.

In still another possible implementation, the first electrode extension portion 311 and the second electrode extension portion 312 are located at two opposite ends of the columnar electrode 26, the first plate 28 and the second plate 29 are located at the two opposite ends of the columnar electrode 26, the first electrode extension portion 311 and the first plate 28 are located at a same end of the columnar electrodes 26, and the second electrode extension portion 312 and the second plate 29 are located at a same end of the columnar electrodes 26. For example, the first electrode extension portion 311 and the first plate 28 are located at the top of the columnar electrode 26, and the second electrode extension portion 312 and the second plate 29 are located at the bottom of the columnar electrode 26. Alternatively, the first electrode extension portion 311 and the first plate 28 are located at the bottom of the columnar electrode 26, and the second electrode extension portion 312 and the second plate 29 are located at the top of the columnar electrode 26.

In this embodiment, as shown in FIG. 5, sizes of the planar electrodes 24 and the first dielectric layers 25 in the X direction may be the same, and sizes of the planar electrodes 24 and the first dielectric layers 25 in the Y direction may also be the same. As shown in FIG. 2b, a step region 1232 is usually disposed on the second surface 1231 of the substrate 123, and sizes of projection of the metal layers M on the step region 1232 in the X direction or the Y direction may be different. In this case, the metal layers M may form a plurality of step structures 1233 shown in FIG. 2a. When the sizes of the planar electrodes 24 and the first dielectric layers 25 in the X direction are the same, and the sizes of the planar electrodes 24 and the first dielectric layers 25 in the Y direction are also the same, an area of the step region 1232 of the memory 12 shown in FIG. 2a is not increased due to a structure of the capacitor 20. In other words, the area of the step region 1232 does not need to be additionally increased. In addition, a spacing area that is of the step structure 1233 in the X direction and that is introduced for a safe distance in a process of manufacturing the step structure 1233 shown in FIG. 2a can be further eliminated.

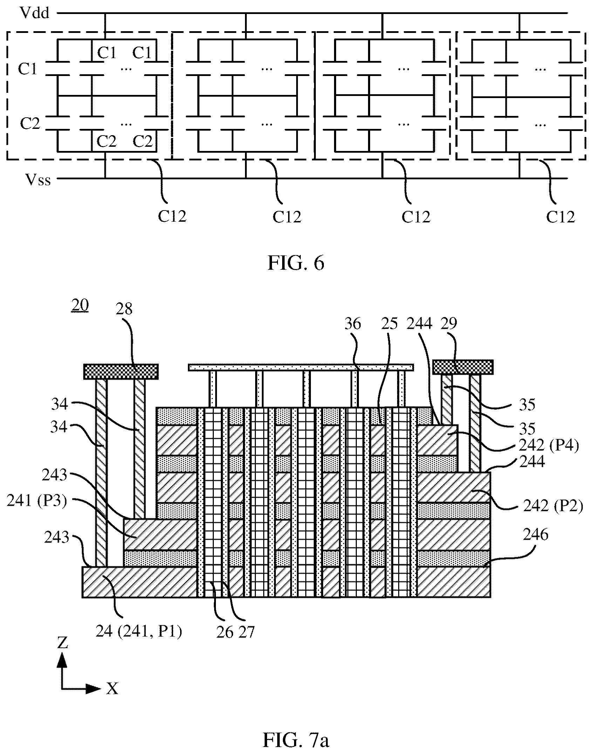

For one planar electrode 24, the planar electrode 24, two columnar electrodes 26, and second dielectric layers 27 located between the planar electrode 24 and the columnar electrodes 26 may form two capacitor units. The first plate 28 may be connected to a power supply voltage end Vdd, and the second plate 29 may be connected to a power supply voltage end Vss. The first plate 28 is disposed on the first columnar electrode 261, and the second plate 29 is disposed on the second columnar electrode 262. In this case, the planar electrode 24, the first columnar electrode 261, and the second dielectric layer 27 located between the planar electrode 24 and the first columnar electrode 261 may form a first capacitor unit C1 shown in FIG. 6, the planar electrode 24, the second columnar electrode 262, and the second dielectric layer 27 located between the planar electrode 24 and the second columnar electrode 262 may form a second capacitor unit C2, and the first capacitor unit C1 and the second capacitor unit C2 are connected in series. In addition, because the at least two columnar electrodes 26 are all located in the first vias 245 of the planar electrode 24, the planar electrode 24 and the at least two first columnar electrodes 261 may form at least two first capacitor units C1, and the at least two first capacitor units C1 are connected in parallel. Similarly, the planar electrode 24 and the at least two second columnar electrodes 262 may form at least two second capacitor units C2, and the at least two second capacitor units C2 are connected in parallel. In other words, it is assumed that the planar electrode 24 corresponds to one combined capacitor C12, the combined capacitor C12 includes at least two first capacitor units C1 and at least two second capacitor units C2. The at least two first capacitor units C1 are connected in parallel, the at least two second capacitor units C2 are connected in parallel, and each first capacitor unit C1 and each second capacitor unit C2 are connected in series.

Combined capacitors C12 corresponding to different planar electrodes 24 are connected in parallel. In other words, the capacitor 20 includes at least two combined capacitors C12, and the combined capacitors C12 are connected in parallel. When the first capacitor units C1 are connected in parallel, the second capacitor units C2 are connected in parallel, and the combined capacitors C12 are connected in parallel, the capacitance value of the capacitor 20 can be improved, to further improve the capacitance density of the capacitor 20. In other words, when a same area is occupied on the second surface of the substrate of the memory, a larger capacitance value can be obtained in embodiments of this application, so that higher capacitance density can be obtained. In addition, in embodiments of this application, three-dimensional space can be further fully used, and a large quantity of planar electrodes 24 and a large quantity of first dielectric layers 25 can be disposed, to obtain higher capacitance density.

In addition, when the first capacitor unit C1 and the second capacitor unit C2 are connected in series, the voltage withstand capability of the capacitor 20 can be improved. In addition, when the first capacitor unit C1 is faulty, the second capacitor unit C2 connected in series to the first capacitor unit C1 can still be used. This can improve reliability of the capacitor 20, and reduce a risk of a fault.

In addition, as shown in FIG. 4a, when the second dielectric layer 27 penetrates from the first via 245 of the planar electrode 24 at the bottom layer to the second via 251 of the first dielectric layer 25 at the top layer, a distribution area of electric field lines generated between the columnar electrode 26 and the planar electrode 24 is larger, and the capacitance density of the capacitor 20 can be further improved.

In addition, when the memory 12 shown in FIG. 2a is manufactured, the metal layers M need to be stacked and processed layer by layer. When the capacitor 20 is manufactured, photoetching, filling, and grinding processes need to be performed. When the memory cell of the memory 12 is manufactured, photoetching, filling, and grinding processes also need to be performed. Therefore, a manufacturing process of the capacitor may be compatible with a manufacturing process of the entire memory 12. This can improve the capacitance density of the capacitor without increasing a process procedure and process costs.

The side surface of the columnar electrode 26 is not limited in embodiments of this application. For example, the side surface of the columnar electrode 26 may be a cylindrical or planar surface. Alternatively, the side surface of the columnar electrode 26 may be a wavy surface. Correspondingly, an inner surface that is of the second dielectric layer 27 and that faces the columnar electrode 26 may also be a wavy surface, to increase a surface area of the second dielectric layer 27. This further improves the capacitance density of the capacitor 20.

A material of the second dielectric layer 27 includes at least one of ZrOₓ, HfOₓ, SiOₓ, AlOₓ, TiOₓ, LaOₓ, TaOₓ, and SiNₓ, and x is greater than 0 and less than or equal to 10. All the foregoing materials are materials with high dielectric constants, and a dielectric constant of the materials is greater than or equal to 20 and less than or equal to 40. Because the capacitance value of the capacitor 20 is positively correlated with a dielectric constant of the second dielectric layer 27, a higher dielectric constant of the second dielectric layer 27 indicates a higher capacitance value of the capacitor 20, and higher capacitance density of the capacitor 20.

In addition, to enable the planar electrodes 24 to be equipotentially bonded, as shown in FIG. 4e, the capacitor 20 may further include a first conductive connection portion 33, and each planar electrode 24 is in contact with the first conductive connection portion 33. A material of the first conductive connection portion 33 may be a conductive material, and the material of the planar electrode 24 is also a conductive material. Therefore, when each planar electrode 24 is in contact with the first conductive connection portion 33, each planar electrode 24 is electrically connected. When a potential of one of the planar electrodes 24 changes, a potential of another planar electrode 24 also changes accordingly.

For a manner in which the first plate 28 and the second plate 29 are connected to the planar electrode 24 or the columnar electrode 26, in another possible implementation, the first plate 28 and the second plate 29 are connected to the at least two planar electrodes 24 respectively. For example, as shown in FIG. 7a, the first plate 28 is connected to a part of the planar electrodes 24, and the second plate 29 is connected to the other part of the planar electrodes 24. For ease of description, the at least two planar electrodes 24 may include the first planar electrode 241 and the second planar electrode 242, there may be one first planar electrode 241 or at least two first planar electrodes 241, and there may also be one second planar electrode 242 or at least two second planar electrodes 242. Herein, an example in which there are at least two first planar electrodes 241 and at least two second planar electrodes 242 is used for description.

The first plate 28 may be connected to a part of the first planar electrodes 241, or may be connected to the first planar electrodes 241 respectively. Similarly, the second plate 29 may be connected to a part of the second planar electrodes 242, or may be connected to the second planar electrodes 242 respectively. It may be understood that the connection herein may be electrical connection.

For example, the first plate 28 is connected to each first planar electrode 241 respectively, and the second plate 29 is connected to each second planar electrode 242 respectively. For example, as shown in FIG. 7a, there are two first planar electrodes 241 and two second planar electrodes 242, the first plate 28 is connected to the two first planar electrodes 241 respectively, and the second plate 29 is connected to the two second planar electrodes 242 respectively.

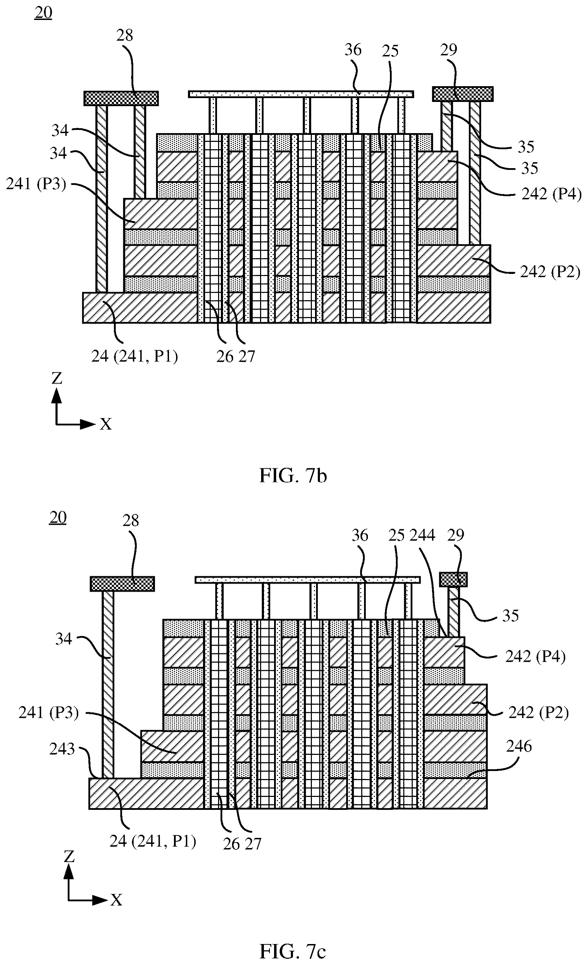

For another example, the first plate 28 is connected to a part of the first planar electrodes 241, and the second plate 29 is connected to a part of the second planar electrodes 242. For example, as shown in FIG. 7c, there are two first planar electrodes 241 and two second planar electrodes 242, the first plate 28 is connected to one of the first planar electrodes 241, and the second plate 29 is connected to one of the second planar electrodes 242.

For another example, the first plate 28 is connected to each first planar electrode 241 respectively, and the second plate 29 is connected to a part of the second planar electrodes 242.

For another example, the first plate 28 is connected to a part of the first planar electrodes 241, and the second plate 29 is connected to each second planar electrode 242 respectively.

In this way, when the capacitor 20 is manufactured, the quantity of first planar electrodes 241 connected to the first plate 28 and the quantity of second planar electrodes 242 connected to the second plate 29 may be selected based on a capacitance requirement of the capacitor 20. In addition, capacitors 20 with different capacitance requirements may be manufactured by using same process procedures and steps, so that the capacitors 20 with different capacitance values can be compatible with a same manufacturing process.

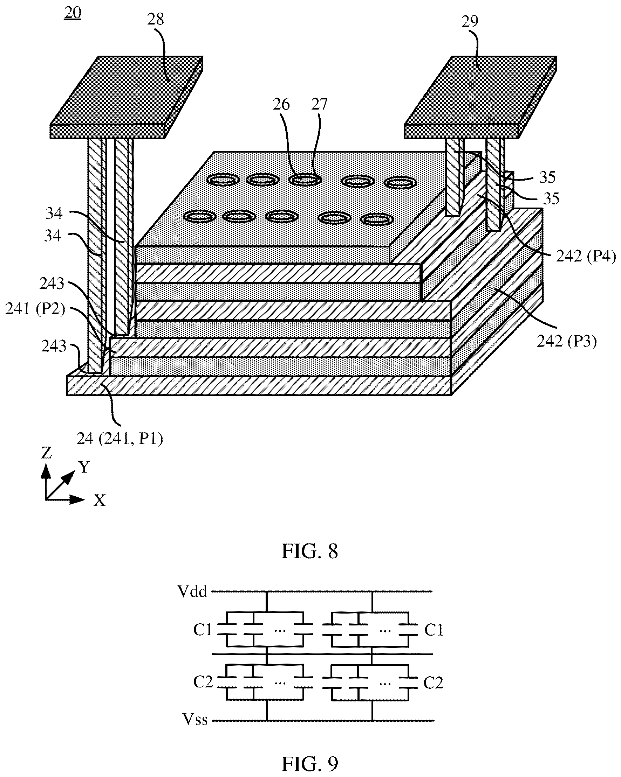

For each first planar electrode 241, the first planar electrode 241, each columnar electrode 26, and the second dielectric layer 27 located between the first planar electrode 241 and the columnar electrode 26 may form one first capacitor unit C1 shown in FIG. 9. In this case, the first planar electrode 241, the at least two columnar electrodes 26, and the second dielectric layers 27 may form at least two first capacitor units C1, and the at least two first capacitor units C1 are connected in parallel. For each second planar electrode 242, the second planar electrode 242, each columnar electrode 26, and the second dielectric layer 27 located between the second planar electrode 242 and the columnar electrode 26 may form one second capacitor unit C2. In this case, the second planar electrode 242, the at least two columnar electrodes 26, and the second dielectric layers 27 may form at least two second capacitor units C2, and the at least two second capacitor units C2 are connected in parallel. A first capacitor unit C1 and a second capacitor unit C2 that are formed based on a same columnar electrode 26 are connected in series. It is assumed that each first planar electrode 241, each second planar electrode 242, and at least two columnar electrodes 26 form one combined capacitor. In this case, the combined capacitor includes at least two first capacitors C1 and at least two second capacitors C2, each first capacitor C1 and each second capacitor C2 are connected in series, a plurality of first capacitor units C1 are connected in parallel, and a plurality of second capacitor units C2 are connected in parallel, to form the combined capacitor. In other words, the capacitor 20 includes a plurality of first capacitor units C1 and a plurality of second capacitor units C2, the plurality of first capacitor units C1 are connected in parallel, the plurality of second capacitor units C2 are connected in parallel, and each first capacitor unit C1 and each second capacitor unit C2 are connected in series. Because there are at least two first planar electrodes 241 and at least two second planar electrodes 242, the capacitor 20 includes a plurality of combined capacitors, and the plurality of combined capacitors are all connected in parallel.

When the plurality of first capacitor units C1 are connected in parallel and the plurality of second capacitor units C2 are connected in parallel, the capacitance value of the capacitor 20 can be improved, to further improve the capacitance density of the capacitor 20. In other words, when a same area is occupied on the second surface of the substrate of the memory, a larger capacitance value can be obtained in embodiments of this application, so that higher capacitance density can be obtained. In addition, in embodiments of this application, three-dimensional space can be further fully used, and a large quantity of planar electrodes 24 and a large quantity of first dielectric layers 25 can be disposed, to obtain higher capacitance density. In addition, when the first capacitor unit C1 and the second capacitor unit C2 are connected in series, the voltage withstand capability of the capacitor 20 can be improved. In addition, when the first capacitor unit C1 is faulty, the second capacitor unit C2 connected in series to the first capacitor unit C1 can still be used. This can improve reliability of the capacitor 20, and reduce a risk of a fault.

In addition, as shown in FIG. 8, the capacitor 20 may further include a second conductive connection portion 34 and a third conductive connection portion 35, the second conductive connection portion 34 is located between the first planar electrode 241 and the first plate 28, and the third conductive connection portion 35 is located between the second planar electrode 242 and the second plate 29. Because the planar electrodes 24 are stacked and spaced apart, the first planar electrode 241 and the second planar electrode 242 are also stacked and spaced apart. In this case, the first planar electrode 241 and the second planar electrode 242 have different heights in the stacking direction. When the second conductive connection portion 34 is located between the first planar electrode 241 and the first plate 28, and the third conductive connection portion 35 is located between the second planar electrode 242 and the second plate 29, heights of the second conductive connection portion 34 and the third conductive connection portion 35 may be set, so that the first plate 28 and the second plate 29 are disposed at a same layer. In addition, when the first plate 28 and the second plate 29 are further manufactured by using a same material, the first plate 28 and the second plate 29 may be manufactured in a same process, to simplify a manufacturing process.

In addition, for selection of the first planar electrode 241 connected to the first plate 28 and selection of the second planar electrode 242 connected to the second plate 29, in a possible implementation, a plurality of consecutive planar electrodes 24 may be selected as the first planar electrode 241, and a plurality of other consecutive planar electrodes 24 are selected as second planar electrodes 242. For example, if the capacitor 20 is divided into a high region and a low region in the Z direction, a height between the high region and the second surface of the substrate is greater than a height between the low region and the second surface of the substrate. In this case, each first planar electrode 241 is located in the high region, and each second planar electrode 242 is located in the low region. Each planar electrode 24 located in the high region may be selected as the first planar electrode 241, and each planar electrode 24 located in the low region may be used as the second planar electrode 242, that is, a height between each first planar electrode 241 and the bottom of the capacitor 20 is higher than a height between each second planar electrode 242 and the bottom. This can reduce cases in which a short circuit occurs between a plurality of second conductive connection portions 34 because some first planar electrodes 241 are located in the high region and some first planar electrodes 241 are located in the low region. In addition, as shown in FIG. 7a, a side edge of the capacitor 20 is usually manufactured into a stair-like structure by using a stair formation process. In the stair formation process, neither the low region nor the high region has a large processing size.

In another possible implementation, as shown in FIG. 7b, in the plurality of first planar electrodes 241 connected to the first plate 28, at least two first planar electrodes 241 are nonconsecutive; and in the plurality of second planar electrodes 242 connected to the second plate 29, at least two second planar electrodes 242 are nonconsecutive. For example, both a 1^{st} planar electrode 24 and a 3^{rd} planar electrode 24 are first planar electrodes 241, and both a 2^{nd} planar electrode 24 and a 4^{th} planar electrode 24 are second first planar electrodes 242.

As shown in FIG. 7a, in every two first planar electrodes 241, the first planar electrode 241 close to the bottom has a first connection region 243, projection that is of the first planar electrode 241 away from the bottom and that is on the first surface 246 does not overlap the first connection region 243, and the second conductive connection portion 34 is disposed in the first connection region 243. Projection that is of the second conductive connection portion 34 and that is on the first planar electrode 241 close to the bottom falls within a range of the first connection region 243. Because the projection that is of the first planar electrode 241 away from the bottom and that is on the first surface 246 does not overlap the first connection region 243, there is no overlap between projection that is on the first surface 246 and that is of a second conductive connection portion 34 disposed on the first planar electrode 241 away from the bottom and projection that is on the first surface 246 and that is of a second conductive connection portion 34 disposed on the first planar electrode 241 close to the bottom. Therefore, a short circuit does not occur between the two second conductive connection portions 34.

Similarly, as shown in FIG. 7a, in every two second planar electrodes 242, the second planar electrode 242 close to the bottom has a second connection region 244, projection that is of the second planar electrode 242 away from the bottom and that is on the first surface 246 does not overlap the second connection region 244, and the third conductive connection portion 35 is disposed in the second connection region 244. Projection of the third conductive connection portion 35 on the first surface 246 falls within the range of the first connection region 243. Because the projection that is of the second planar electrode 242 away from the bottom and that is on the first surface 246 does not overlap the first connection region 243, there is no overlap between projection that is on the first surface 246 and that is of a third conductive connection portion 35 disposed on the second planar electrode 242 away from the bottom and projection that is on the first surface 246 and that is of a third conductive connection portion 35 disposed on the second planar electrode 242 close to the bottom. Therefore, a short circuit does not occur between the two third conductive connection portions 35.

As shown in FIG. 7a, the first plate 28 and the second plate 29 are respectively located on two sides of the columnar electrode 26. For ease of description, the two sides are a first side and a second side. In this way, each second conductive connection portion 34 may be located at the first side of the columnar electrode 26, and each third conductive connection portion 35 may be located at the second side of the columnar electrode 26, to increase a distance between any second conductive connection portion 34 and any third conductive connection portion 35, and reduce cases in which a short circuit occurs between second conductive connection portions 34 and third conductive connection portions 35.

In addition, to enable the columnar electrodes 26 to be equipotentially bonded, as shown in FIG. 7a, the capacitor 20 further includes a fourth conductive connection portion 36, and each columnar electrode 26 is in contact with the fourth conductive connection portion 36. A material of the fourth conductive connection portion 36 may be a conductive material, and the material of the columnar electrode 26 is also a conductive material. Therefore, when each columnar electrode 26 is in contact with the fourth conductive connection portion 36, each columnar electrode 26 is electrically connected. When a potential of one of the columnar electrodes 26 changes, a potential of another columnar electrode 26 also changes accordingly.

The foregoing describes embodiments of this application with reference to the accompanying drawings. However, this application is not limited to the foregoing specific implementations. The foregoing specific implementations are merely examples, but are not limitative. Inspired by this application, a person of ordinary skill in the art may further make modifications without departing from the purposes of this application and the protection scope of the claims, and all the modifications shall fall within the protection of this application.

## Claims

1. A capacitor, comprising:
at least two planar electrodes that are spaced apart and stacked, wherein each planar electrode is provided with a first via;
a first dielectric layer, wherein the first dielectric layer is located between the two adjacent planar electrodes;
a columnar electrode, wherein at least a part of the columnar electrode is located in the first vias of the at least two planar electrodes;
a second dielectric layer, wherein at least a part of the second dielectric layer is located in the first vias of the at least two planar electrodes, and the second dielectric layer surrounds a side surface of the columnar electrode; and
a first plate and a second plate, wherein the first plate is connected to at least one first planar electrode in the at least two planar electrodes, and the second plate is connected to at least one second planar electrode in the at least two planar electrodes; or there are at least two columnar electrodes, the first plate is connected to at least one first columnar electrode in the at least two columnar electrodes, and the second plate is connected to at least one second columnar electrode in the at least two columnar electrodes.

2. The capacitor according to claim 1, wherein the first dielectric layer is provided with a second via, projection of the first via on the planar electrode overlaps projection of the second via on the planar electrode, a part of the columnar electrode is further located in the second via, and a part of the second dielectric layer is further located in the second via.

3. The capacitor according to claim 1 or 2, wherein each planar electrode is provided with at least two first vias, the capacitor comprises at least two columnar electrodes and at least two second dielectric layers, the at least two columnar electrodes are respectively located in the at least two first vias of each planar electrode, and the at least two second dielectric layers are respectively located in the at least two first vias of each planar electrode.

4. The capacitor according to claim 3, wherein the first plate is connected to a part of the columnar electrodes, and the second plate is connected to the other part of the columnar electrodes.

5. The capacitor according to claim 4, wherein the capacitor further comprises at least two electrode extension portions disposed on the at least two columnar electrodes respectively, the first plate is in contact with a part of the electrode extension portions, and the second plate is in contact with the other part of the electrode extension portions.

6. The capacitor according to claim 5, wherein the electrode extension portion in contact with the first plate and the electrode extension portion in contact with the second plate are located at a same end of the columnar electrodes, and the first plate and the second plate are at a same layer and are of a same material.

7. The capacitor according to any one of claims 4 to 6, wherein the capacitor further comprises a first conductive connection portion, and each planar electrode is in contact with the first conductive connection portion.

8. The capacitor according to any one of claims 1 to 3, wherein the first plate is connected to a part of the planar electrodes, and the second plate is connected to the other part of the planar electrodes.

9. The capacitor according to claim 8, wherein the capacitor further comprises a second conductive connection portion and a third conductive connection portion; and
the at least two planar electrodes comprise the first planar electrode and the second planar electrode, the second conductive connection portion is located between the first planar electrode and the first plate, and the third conductive connection portion is located between the second planar electrode and the second plate.

10. The capacitor according to claim 9, wherein there are at least two first planar electrodes and at least two second planar electrodes; and
a height from each first planar electrode to a bottom of the capacitor is higher than a height from each second planar electrode to the bottom.

11. The capacitor according to claim 10, wherein in every two first planar electrodes, a first planar electrode close to the bottom has a first connection region, projection that is of the first planar electrode away from the bottom and that is on the first planar electrode close to the bottom does not overlap the first connection region, and the second conductive connection portion is disposed in the first connection region.

12. The capacitor according to claim 10 or 11, wherein in every two second planar electrodes, the second planar electrode close to the bottom has a second connection region, projection that is of the second planar electrode away from the bottom and that is on the second planar electrode close to the bottom does not overlap the second connection region, and the third conductive connection portion is disposed in the second connection region.

13. The capacitor according to any one of claims 8 to 12, wherein the first plate and the second plate are respectively located at two sides of the columnar electrode.

14. The capacitor according to any one of claims 8 to 13, wherein the capacitor further comprises a fourth conductive connection portion, and each columnar electrode is in contact with the fourth conductive connection portion.

15. The capacitor according to any one of claims 1 to 14, wherein a surface that is of the second dielectric layer and that faces the columnar electrode is a wavy surface.

16. The capacitor according to any one of claims 1 to 15, wherein a material of the second dielectric layer comprises at least one of ZrOₓ, HfOₓ, SiOₓ, AlOₓ, TiOₓ, LaOₓ, TaOₓ, and SiNₓ, and x is greater than 0 and less than or equal to 10.

17. A memory array, comprising a switching transistor and the capacitor according to any one of claims 1 to 16, wherein the switching transistor is electrically connected to the capacitor.

18. A memory, comprising a controller and the memory array according to claim 17, wherein the controller is electrically connected to the memory array.

19. An electronic device, comprising a circuit board and the memory according to claim 18, wherein the circuit board is electrically connected to the memory.
